# EUROPEAN PATENT APPLICATION

(11) **EP 1 830 396 A1**
(43) Date of publication of application: **05.09.2007**
(21) Application number: 05820274.8
(22) Date of filing: 19.12.2005
(51) Int. Cl.: H01L 21/205, H01L 21/22, H01L 21/324

(54) **MAGNETIC FLUID SEALING UNIT FOR SEMICONDUCTOR WAFER VERTICAL HEAT TREATING APPARATUS**

(30) Priority: 21.12.2004 JP 2004370014
(71) Applicant: Rigaku Corporation, Akishima-shi, Tokyo 196-8666 (JP)
(72) Inventor: SHIMAZAKI, Yasuyuki Rigaku Mechatronics Co., Ltd., Akishima-shi, Tokyo 196-8666 (JP); NOGUCHI, Manabu Rigaku Mechatronics Co., Ltd., Akishima-shi, Tokyo 196-8666 (JP)
(74) Representative: Oser, Andreas
(86) International application number: PCT/JP2005/023693
(87) International publication number: WO 2006/068260

(57) **Abstract**

An outer shell member (60) is fixed to the lower end of a rotational shaft (20) so as to wrap around a unit main body (30) from the lower side thereof to the outer periphery thereof. The gap between the rotational shaft (20) and the unit main body (30) is magnetically sealed by a ferrofluid seal portion (40). A bearing portion (70) is provided at the lower end portion of the unit main body (30) between the unit main body (30) and the outer shell member (60). Purge gas is supplied to the gap between the rotational shaft (20) and the unit main body (30) at a position nearer to the reaction container than the ferrofluid seal portion (40) and in the neighborhood of the ferrofluid seal portion (40) .

## Description

### Technical Field

The present invention relates to a ferrofluid seal unit used on a vertical thermal processing furnace system for semiconductor wafer in which plural processing target boards are held by a holding assembly so as to be spaced from one another at a fixed interval in the vertical direction and the processing target boards in a reaction container kept under a slight pressure or vacuum and high-temperature state are subjected to a heat treatment while rotating the holding assembly in the reaction container.

### Background Art

This type of vertical thermal processing furnace system has been used in film formation processing, oxidation processing, anneal processing, diffusion processing of impurities, etc. for semiconductor wafers.

This type of vertical thermal processing furnace system is configured so that a wafer board (holding assembly) for holding semiconductor wafers are held so as to be spaced from one another at a fixed interval in the vertical direction is accommodated into a reaction container from the lower side thereof, and then the opening portion of the lower end of the reaction container is hermetically sealed by a bottom lid member.

The holding assembly is rotated in the reaction container so that the semiconductor wafers are uniformly subjected to thermal processing. Therefore, a ferrofluid seal unit is assembled to the bottom portion of the reaction container. The ferrofluid seal unit is configured so that a bearing portion for freely rotatably supporting a rotational shaft penetrating through the bottom lid member of the reaction container and a seal portion for preventing leak (leakage) of reaction gas supplied into the reaction container and preventing invasion of outside air into the reaction container, the bearing portion and the seal portion are installed in the main body of the unit.

In general, the main body of the unit is designed in a cylindrical shape, and mounted to the bottom lid member so that the hollow portion thereof intercommunicates with the shaft hole of the bottom lid member of the reaction container. The bearing portion is disposed at the lower portion of the unit main body so as to support the rotational shaft. The seal portion is basically disposed at the upper portion of the unit main body so as to seal the gap between the unit main body and the rotational shaft. Ferrofluid is used for the seal portion. The seal portion based on ferrofluid is provided at the upper portion of the unit main body to prevent contamination or particles occurring from the bearing from invading into the reaction container and also prevent the function of the bearing frombeing declined by reaction gas used for the thermal processing or reaction by-product materials.

In the thus-constructed ferrofluid seal unit, the seal portion is located near to the reaction container. Therefore, when the reaction gas supplied into the reaction container or the reaction by-product gas comes into contact with the ferrofluid of the seal portion through the shaft hole and thus is adsorbed or cooled by the ferrofluid, the reaction by-product materials are generated, and the reaction by-product materials adhere to the ferrofluid, the surface of the rotational shaft or the surface of the shaft hole of the unit main body, so that the ferrofluid is deteriorated. This shortens the lifetime of the ferrofluid and causes leakage of the ferrofluid and fixing of the rotational shaft. Furthermore, the reaction by-product materials adhering to the ferrofluid, the surface of the rotational shaft and the surface of the shaft hole of the unit main body causes occurrence of particles.

The seal portion provided at the upper portion of the unit main body is liable to suffer high heat because it is near to the bottom lid member of the reaction container under high temperature, and thus deterioration of the ferrofluid due to high heat is required to be prevented.

In general, a water cooling portion is provided in the unit main body of the outer periphery of the seal portion to cool the ferrofluid seal portion. The cooling lowers not only the temperature of the ferrofluid, but also the ambient temperature, so that it promotes the adherence of the reaction by-product materials and also induces occurrence of particles.

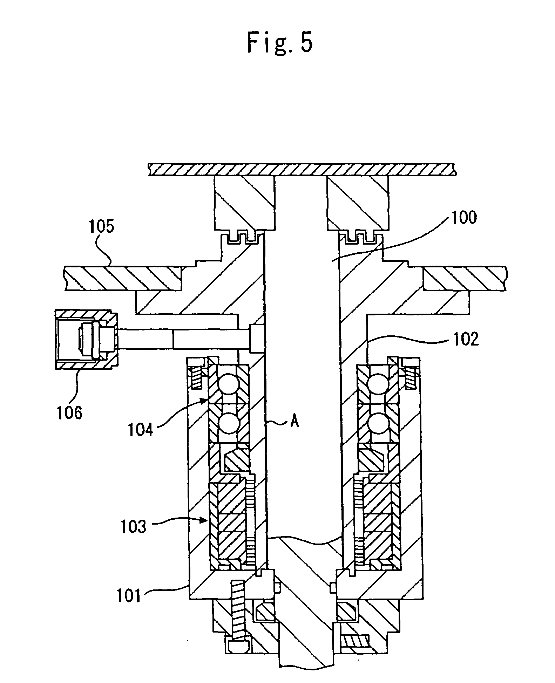

Therefore, in a prior art disclosed in JP-A-2000-216105, an outer shell member 101 is secured to the lower end of a rotational shaft 100, and a seal portion 103 (ferrofluid seal portion) and a bearing portion 104 are disposed at the outside of a unit main body 102 (fixing member) as shown in Fig. 5, whereby the above members are spaced from a bottom lid member 105 of a reaction container. Furthermore, a gas supplypath 106 for supplying purge gas is made to intercommunicate with the gap between the rotational shaft 100 and the unit main body 102 at a position nearer to the bottom lid member 105 of the reaction container than the seal portion 103, thereby preventing reaction gas from the reaction container and reaction by-product gas from coming into contact with the seal portion 103.

However, when the ferrofluid seal unit is constructed as shown in the prior art shown in Fig. 5, the purge gas supply portion based on the gas supply path 106 is far away from the seal portion. Therefore, the gap A extending from the purge gas supply portion 106 to the ferrofluid seal portion 103 serves as a retention portion in which no gas flow is formed, and thus contamination, impurity gas (water vapor, reaction by-product gas, others), particles, etc. easily stay, so that these materials may invade into the reaction container and pollute semiconductor wafers to be thermally processed for some reason. In the long view, it may cause deterioration of the ferrofluid.

Furthermore, the bearing portion 104 is located near the bottom lid member 105 of the reaction container which is set to high temperature. Therefore, the bearing portion 104 is liable to undergo high-heat effect, and thus there is a risk that the performance of the bearing portion 104 is lowered, the bearing portion 104 conks, etc. In addition, in order to prevent the foregoing problems, there is a probability that a cooling portion must be provided at the upper side of the bearing portion. This may cause occurrence of particles described above.

The present invention has been implemented in view of the foregoing situation, and has an object to perfectly eliminate a retention portion in which contamination, impurity gas (water vapor, reaction by-product gas, others), particles, etc. stay between the unit main body and the rotational shaft, adopt air cooling and the corresponding structure with eliminating cooling based on water cooling, and suppress deterioration of ferrofluid and occurrence of particles due to high heat, adsorption of impurity gas and adhesion of reaction by-product materials, and performance deterioration or breakdown of the bearing, occurrence of particles, etc. due to high temperature.

### Disclosure of the Invention

According to the present invention, a ferrofluid seal unit used on a vertical thermal processing furnace system in which plural processing target boards are held by a holding assembly so as to be spaced from one another at a fixed interval in the vertical direction and the processing target boards in a reaction container under a slight pressure or vacuum and high-temperature state are subjected to a heat treatment while rotating the holding assembly in the reaction container is characterized by comprising:
a rotational shaft that enters the reaction container through a shaft hole formed in the bottom portion of the reaction container and transmits rotational driving force to the holding assembly;
a cylindrical unit main body that is mounted at the outside of the bottom portion of the reaction container and equipped with a support hole intercommunicating with the shaft hole, the rotational shaft being inserted into the support hole;
an outer shell member that is fixed to the lower end of the rotational shaft and wraps around the unit main body from the lower side thereof to the outer periphery thereof;
a ferrofluid seal portion for sealing the gap between the rotational shaft and the unit main body by using ferrofluid;
a bearing portion provided to the lower end portion of the unit main body between the unit main body and the outer shell member; and
a gas supply path for supplying purge gas to the gap between the rotational shaft and the unit main body at a position that is nearer to the reaction container side than the ferrofluid seal portion and in the neighborhood of the ferrofluid seal portion.

Here, the ferrofluid seal portion is preferably installed at the lower position of the unit main body to reduce heat effect.

Radiating means is preferably formed in the unit main body between a mount portion of the unit main body to be mounted to the bottom portion of the reaction container and an installation portion of the unit main body for the ferrofluid seal portion.

The radiating means may be configured to have a required minimum cross sectional area that is set so that the cross sectional area of the unit main body is smaller than that of the installation portion of the ferrofluid seal portion. Accordingly, the heat conduction amount can be minimized. Furthermore, the radiating means may be constructed by a radiation fin formed on the outer surface of the unit main body.

It is preferable that the rotational shaft has a hollow portion formed from the lower end thereof over a fixed length on the center axis thereof, and a thermal conduction shaft formed of a material having a higher thermal conductivity than the rotational shaft is installed in the hollow portion so as to internally touch the hollow portion. Here, the thermal conduction shaft has a function of forming a bridge to efficiently conduct heat, and it is preferable that the thermal conduction shaft is made to internally touch any place on the inner wall of the hollow portion in consideration of a desired thermal conduction efficiency. The thermal conduction shaft is movable in the axial direction.

The gap portion to which the purge gas is supplied from the gas supply path is preferably equipped with a groove having a larger volume than the other gap portions.

Furthermore, it is preferable that a pair of or plural concentric labyrinths which are concentric with the rotational shaft are formed between the rotational shaft and the unit main body in the neighborhood of a shaft hole formed in the bottom portion of the reaction container. Accordingly, the uniform gas purge can be performed around the rotational shaft and a gas retention portion can be eliminated.

According to the present invention, in the neighborhood of the ferrofluid seal portion, the purge gas can be uniformly supplied from the gas supply portion to the gap between the rotational shaft and the unit main body, and thus there is no risk that contamination, impurity gas (water vapor, reaction by-product gas, others), particles, etc. stay between the supply portion of the purge gas and the ferrofluid seal portion. Therefore, there is no risk that wafers to be thermally processed are polluted and ferrofluid is deteriorated in the long view. Furthermore, since water cooling is not adopted, supercooling can be avoided and thus adhesion of reaction by-product materials can be prevented, so that occurrence of particles can be prevented.

Furthermore, performance deterioration and breakdown of the bearing due to high heat can be suppressed.

The thermal processing temperature range in which the ferrofluid seal portion can be set to the optimum temperature with respect to different thermal processing temperature can be broadened by the thermal conduction shaft which can be mounted in the hollow portion of the rotational shaft, so that the deterioration of ferrofluid due to high heat can be suppressed.

### Brief Description of the Drawings

Fig. 1 is a diagram showing a construction example of a vertical thermal processing furnace system in which a ferrofluid seal unit according to an embodiment of the present invention is installed.
Fig. 2 is a frontal sectional view showing a construction example of a ferrofluid seal unit according to the embodiment of the present invention.
Fig. 3 is a frontal sectional view showing another construction example of the ferrofluid seal unit according to the embodiment of the present invention.
Fig. 4 is a frontal sectional view showing another construction example of the ferrofluid seal unit according to the embodiment of the present invention.
Fig. 5 is a frontal sectional view showing a conventional ferrofluid seal unit.

### Best Mode for Carrying out the Invention

A preferred embodiment of the present invention will be described with reference to the drawings.

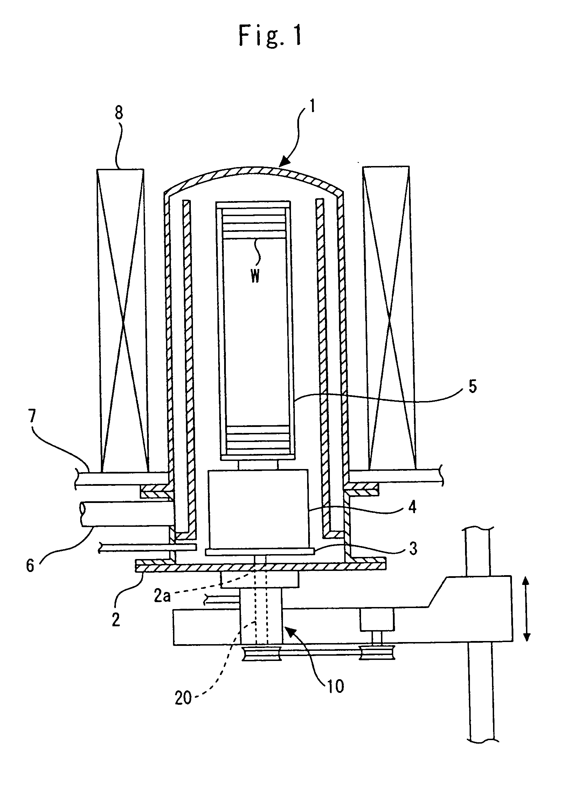

First, a reaction container of a vertical thermal processing furnace system and the surrounding construction of the bottom portion of the reaction container will be described with reference to Fig. 1. Fig. 1 is a diagram showing a construction example of a vertical thermal processing furnace system in which a ferrofluid seal unit according to an embodiment of the present invention is installed.

The reaction container 1 has an opened bottom portion, and the opening portion of the bottom portion is covered by a bottom lid member 2. In the construction shown in Fig. 1, the bottom lid member 2 also constitutes a part of the reaction container 1. The bottom lid member 2 is freely movable upwardly and downwardly. A shaft hole 2a is formed at the center portion of the bottom lid member 2, and the upper portion of the rotational shaft 20 penetrates through the shaft hole 2a so as to protrude to the upper side of the bottom lid member 2.

A turntable 3 is mounted on the upper end of the rotational shaft 20, and a wafer boat 5 (holding assembly) is mounted on the upper surface of the turntable 3 through a heat insulating mould. The wafer boat 5 is a member for holding semiconductor wafers W (boards to be processed) so that the semiconductor wafers W are spaced from one another at a fixed interval in the vertical direction. The turntable 3, the heat insulating mould 4 and the wafer boat 5 are upwardly and downwardly movable integrally with the bottom lid member 2.

At the descent position, the semiconductor wafers W are disposed in the wafer boat 5, and at the ascent position the wafer boat 5 is accommodated in the reaction container 1 and the opening portion of the bottomportion of the reaction container 1 is covered by the bottom lid member 2. An exhaust pipe 6 and a gas supplypipe 7 intercommunicate with the inside of the reaction container 1 so that the inside of the reaction container is vacuum-pumped through the exhaust pipe 6 and then reaction gas is supplied from the gas supply pipe 7 into the reaction container 1.

Furthermore, a heating furnace 8 is disposed on the outer periphery of the reaction container 1, and the semiconductor wafers W held in the wafer boat 5 are heated and thermally processed by radiation heat from the heating furnace 8.

A ferrofluid seal unit 10 of this embodiment is secured to the bottom lid member 2.

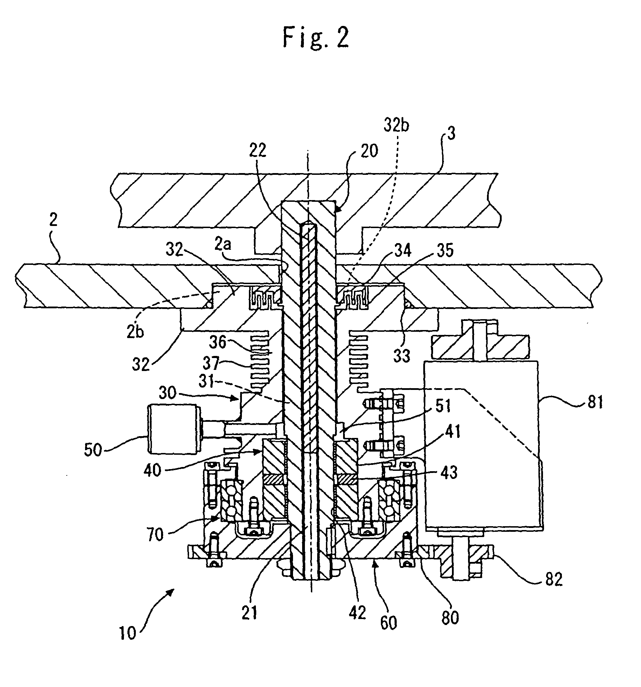

Figs. 2 to 4 are frontal sectional views showing the construction of the ferrofluid seal unit according to the embodiment.

The main part of the ferrofluid seal unit 10 comprises the rotational shaft 20 described above, a unit main body 30, a ferrofluid seal portion 40, a gas supply portion 50, an outer shell member 60 and a beating portion 70.

The unit main body 30 is formed of nonmagnetic material, and a support hole 31 through which the rotational shaft 20 is inserted is formed at the center axial portion of the unit main body 30 so as to penetrate in the vertical direction. Furthermore, a flange 32 is formed at the upper end portion of the unit main body 30, and the flange 32 constitutes a mount portion for the bottom lid member 2. The flange 32 is fixed to the lower surface of the bottom lid member 2 by a fastening member such as a bolt or the like.

Here, a recess groove 2b is formed on the lower surface of the bottom lid member 2 so as to surround the shaft hole 2a, and a projecting portion 32a is formed on the upper surface of the flange 32 so as to be engaged with the recess groove 2b. An O-ring 33 is provided at the step portion between the recess groove 2b and the projecting portion 32a, and the engaging portion is hermetically sealed by the 0-ring 33.

A cut-out portion 32b is formed at the center portion of the upper surface of the projecting portion 32a of the flange 32 so as to be continuous with the support hole 31, and plural upwardly-projecting ridges are concentrically formed on the bottom surface of the cut-out portion 32b. A disc member 34 is mounted on the outer periphery of the rotational shaft 20 so as to face the cut-out portion 32b, and plural downwardly-projecting ridges are concentrically formed on the lower surface of the disc member 34. These ridges are engaged with one another and a zigzag labyrinth 35 is formed therebetween.

A slight gap is formed between the upper surface of the disc member 34 mounted on the outer periphery of the rotational shaft 20 and the ceiling surface of the recess groove 2b formed on the bottom lid member 2, and this gap intercommunicates with the gap between the shaft hole 2a and the rotational shaft 20. Furthermore, the gap between the disc member 34 and the bottom lid member 2 intercommunicates with the opening portion of the outside of the labyrinth 35, and the opening portion of the inside of the labyrinth 35 intercommunicates with the gap between the main body of the flange 32 formed at the lower side of the disk member 34 and the rotational shaft 20.

A ferrofluid seal portion 40 is provided along the support hole 31 at the lower portion of the unit main body 30.

The ferrofluid seal portion 40 comprises a cylindrical pole piece 41 mounted in the unit main body 30, and ferrofluid 42 filled in the gap between the inner peripheral surface of the pole piece 41 and the outer peripheral surface of the rotational shaft 20. A permanent magnet 43 is installed in the pole piece 41. The rotational shaft 20 is formed of magnetic metal. Therefore, a magnetic circuit is formed between the permanent magnet 43 installed in the pole piece 41 and the rotational shaft 20, and the ferrofluid 42 is held in the gap by the magnetic force acting on this magnetic circuit.

The gas supply path 50 intercommunicates with the gap between the rotational shaft 20 and the unit main body 30 at a position which is nearer to the reaction container 1 than the ferrofluid seal portion 40 and in the neighborhood of the ferrofluid seal portion 40, and supplies purge gas such as nitrogen gas or the like from the position concerned into the gap concerned. The gap portion to which the purge gas is supplied from the gas supply path 50 is provided with a groove 51 having a larger volume than the other gap portions. The groove 51 may be formed by providing a recessed ridge on the inner wall of the unit main body 30 or the outer periphery of the rotational shaft 20.

The outer shell member 60 is configured to have a shallow bottomed cylindrical shape (bowl-shape), and the center portion thereof is fixed to the lower end of the rotational shaft 20 so that the outer shell member 60 rotates integrally with the rotational shaft 20. The inner bottom surface of the outer shell member 60 faces the bottom surface of the unit main body 30, and the internal surface of the outer shell member 60 faces the outer peripheral surface of the unit main body 30. That is, the outer shell member 60 is disposed so as to wrap around the unit main body 30 from the lower portion thereof to the outer periphery thereof. A bearing portion 70 comprising a ball bearing or the like is provided between the internal surface of the outer shell member 60 and the unit main body 30.

A driven gear 80 is fixed to the outer peripheral surface of the outer shell member 60, and it is engaged with a driving gear 82 mounted on the driving shaft of a driving motor 81 to transfer the rotational driving force from the driving motor 81 to the rotational shaft 20. Each gear constitutes a decelerating mechanism.

With respect to the unit main body 30, the intermediate portion thereof which is located between the flange 32 serving as the mount portion to be mounted on the bottom lid member 2 of the reaction container 1 and the installation portion in which the ferrofluid seal portion 40 is installed is configured as a small-diameter portion 36 which is smaller in cross sectional area than the installation portion concerned. Furthermore, the outer surface of the small-diameter portion 36 is equipped with a radiation fin 37 so that a large surface area is secured.

Furthermore, a hollow portion 21 is formed in the rotational shaft 20 so as to extend from the lower end of the rotational shaft 20 on the center axis thereof over a fixed length, and a heat conduction shaft 22 is freely detachably inserted in the hollow portion 21. In this embodiment, a female screw is formed on the inner wall of the hollow portion 21 while a male screw is formed on the outer peripheral surface of the heat conduction shaft 22, and the heat conduction axis 22 can be moved to any position through the engagement between the female screw and the male screw.

The heat conduction shaft 22 is formed of a material having a higher thermal conductivity than the rotational shaft 20. For example, when the rotational shaft 20 is formed of magnetic stainless, the heat conduction shaft may be formed of aluminum alloy or copper alloy.

Next, the action of the thus-constructed ferrofluid seal unit 10 will be described.

First, in the ferrofluid seal unit 10 of this embodiment, the ferrofluid seal portion 40 is provided at the lower side of the unit main body 30 which is far away from the reaction container 1, and thus it is little affected by heat transferred from the inside of the reaction container 1 through the rotational shaft 20. Furthermore, the small-diameter portion 36 of the unit main body 30 which is small in cross sectional area is interposed between the reaction container 1 and the ferrofluid seat portion 40, and thus the heat conduction amount at the small-diameter portion 36 is reduced. In addition, the radiation fin 37 is formed on the outer surface of the small-diameter portion 36, and thus heat is radiated to the atmosphere, so that heat is more hardly transferred to the ferrofluid seal portion 40. By providing the radiating means as described above, the ferrofluid 42 filled in the ferrofluid seal portion 40 can be suppressed from being deteriorated by heat.

Furthermore, the hollow portion 21 is formed at the center axis portion of the rotational shaft 20, and the heat conduction shaft 22 is freely detachably inserted in the hollow portion 21, whereby the temperature of the ferrofluid seal portion 40 can be adjusted on the basis of the position of the heat conduction shaft 22. The outer periphery of the rotational shaft 20 is liable to be thermally cooled because it is near to the atmosphere through the unit main body 30, however, the center axis portion of the rotational shaft 20 is under high temperature. Therefore, the heat conduction amount transferred through the rotational shaft 20 is largest at the center axis portion. Accordingly, by forming the hollow portion 21 at the center axis portion, the heat conduction can be further remarkably delayed.

When the thermal processing temperature is relatively low, it may be required to positively transfer the heat in the reaction container 1 to the ferrofluid seal portion 40 so that the temperature of the ferrofluid 42 of the ferrofluid seal portion 40 is increased to a proper temperature. In this case, if the thermal conduction shaft 22 is inserted into the hollow portion 21 as shown in Fig. 2, heat can be quickly transferred to the ferrofluid seal portion 40 through the thermal conduction shaft 22.

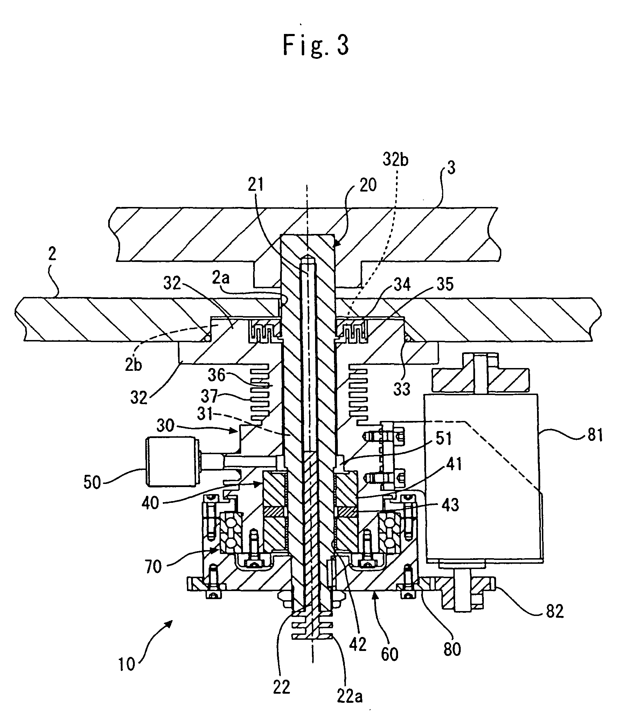

The heat transfer amount can be adjusted to some extent on the basis of the diameter of the thermal conduction shaft 22, the insertion length of the thermal conduction shaft 22 into the hollow portion 21 and the position of the thermal conduction shaft 22 in the hollow portion 21. When the temperature of the ferrofluid seal portion is required to be reduced, for example, the tip of the thermal conduction shaft 22 is disposed at the slightly upper side of the upper end of the ferrofluid seal portion, the base end of the thermal conduction shaft 22 is made to protrude from the lower end face of the rotational shaft to the outside and a radiation fin 22a is formed at the protrusion portion concerned as shown in Fig. 3, whereby heat can be efficiently radiated to the atmosphere and thus the temperature of the ferrofluid seal portion 40 can be reduced.

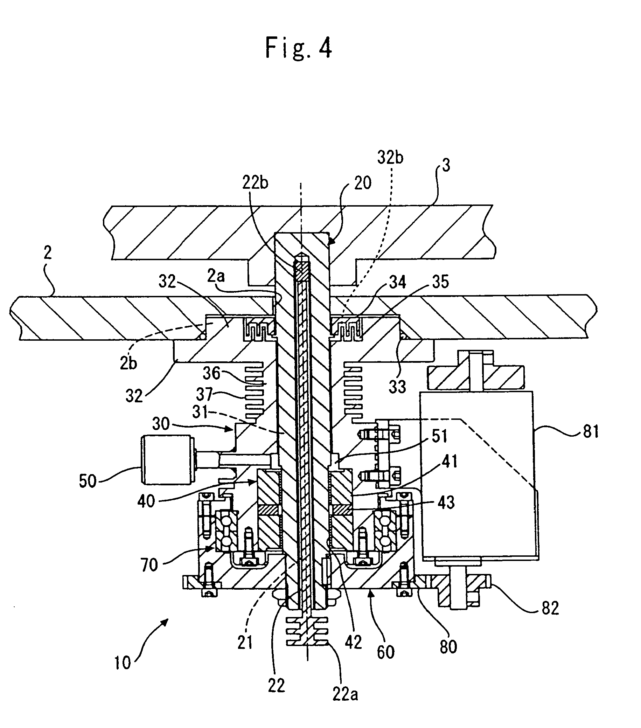

Furthermore, as shown in Fig. 4, a male screw portion 22b is formed at only the tip portion of the thermal conduction shaft 22, and the tip portion of the thermal conduction shaft 22 is made to internally touch the inner wall of the hollow portion of the rotational shaft 20. In addition, the base end of the thermal conduction shaft 22 is made to protrude from the lower end face of the rotational shaft, and the radiation fin 22a is formed at the protrusion portion. This construction can also efficiently radiate heat to the atmosphere and reduce the temperature of the ferrofluid seal portion 40. The intermediate portion of the thermal conduction shaft 22 is narrowed in diameter so that the intermediate portion does not internally touch the inner wall of the hollow portion of the rotational shaft 20.

The purge gas supplied from the gas supply path 50 is passed from the gap between the unit main body 30 and the rotational shaft 20 through the labyrinth 35 to the shaft hole 2a of the bottom lid member 2 and then fed from the shaft hole 2a into the reaction container 1. Therefore, there is no risk that the reaction gas filled in the reaction container 1 leaks from the shaft hole 2a.

The groove 51 is formed at the supply portion of the purge gas from the gas supply portion 50, and thus the purge gas uniformly flows into the gap surrounding the rotational shaft without retention. The supply portion of the purge gas is provided in proximity to the ferrofluid seal portion 40, and thus there is no risk that contamination, impurity gas (water vapor, reaction by-product gas, others), particles, etc. stay between the supply portion of the purge gas and the ferrofluid portion 40. Therefore, there is no risk that wafers to be thermally processed are polluted and the ferrofluid is deteriorated in the long view.

The present invention is not limited to the above-described embodiment, and various modifications or applications may be performed.

### Industrial Applicability

According to the present invention having the above construction, purge gas can be uniformly supplied from the gas supply portion to the gap between the rotational shaft and the unit main body in the neighborhood of the ferrofluid seal portion. Therefore, there is no risk that contamination, impurity gas (water vapor, reaction by-product gas, others), particles, etc. stay between the supply portion of the purge gas and the ferrofluid seal portion, and also there is no risk that wafers to be thermally processed are polluted and the ferrofluid is deteriorated in the long view. Furthermore, since water cooling is not adopted, supercooling can be avoided, adhesion of reaction by-product materials can be prevented and occurrence of particles can be suppressed.

Furthermore, the performance deterioration, breakdown of the bearing due to high heat can be suppressed.

The thermal processing temperature range in which the ferrofluid seal portion can be set to the optimum temperature with respect to different thermal processing temperature can be broadened by the thermal conduction shaft which can be mounted in the hollow portion of the rotational shaft, so that the deterioration of ferrofluid due to high heat can be suppressed.

## Claims

1. A ferrofluid seal unit used on a vertical thermal processing furnace system in which plural processing target boards are held by a holding assembly so as to be spaced from one another at a fixed interval in the vertical direction and the processing target boards in a reaction container under a slight pressure or vacuum and high-temperature state are subjected to a heat treatment while rotating the holding assembly in the reaction container, **characterized by** comprising:
a rotational shaft that enters the reaction container through a shaft hole formed in the bottom portion of the reaction container and transmits rotational driving force to the holding assembly;
a cylindrical unit main body that is mounted at the outside of the bottom portion of the reaction container and equipped with a support hole intercommunicating with the shaft hole, the rotational shaft being inserted into the support hole;
an outer shell member that is fixed to the lower end of the rotational shaft and wraps around the unit main body from the lower side thereof to the outer periphery thereof;
a ferrofluid seal portion for sealing the gap between the rotational shaft and the unit main body by using ferrofluid;
a bearing portion provided to the lower end portion of the unit main body between the unit main body and the outer shell member; and
a gas supply portion for supplying purge gas to the gap between the rotational shaft and the unit main body at a position that is nearer to the reaction container side than the ferrofluid seal portion and in the neighborhood of the ferrofluid seal portion.

2. The ferrofluid seal unit according to claim 1, wherein the ferrofluid seal portion is installed at the lower position of the unit main body.

3. The ferrofluid seal unit according to claim 1, wherein radiating means is formed in the unit main body between a mount portion of the unit main body to be mounted to the bottom portion of the reaction container and an installation portion of the unit main body for the ferrofluid seal portion.

4. The ferrofluid seal unit according to claim 3, wherein the radiating means is configured so that the cross sectional area of the unit main body is smaller than that of the installation portion of the ferrofluid seal portion.

5. The ferrofluid seal unit according to claim 3, wherein the radiating means comprises a radiation fin formed on the outer surface of the unit main body.

6. The ferrofluid seal unit according to claim 1, wherein the rotational shaft has a hollow portion formed from the lower end thereof over a fixed length on the center axis thereof, and a thermal conduction shaft formed of a material having a higher thermal conductivity than the rotational shaft is installed in the hollow portion so as to internally touch the hollow portion, and the thermal conduction shaft is movable in the axial direction.

7. The ferrofluid seal unit according to claim 1, wherein the gap portion to which the purge gas is supplied from the gas supply path is equipped with a groove having a larger volume than the other gap portions.

8. The ferrofluid seal unit according to claim 1, wherein a pair of or plural concentric labyrinths which are concentric with the rotational shaft are formed between the rotational shaft and the unit main body in the neighborhood of a shaft hole formed in the bottom portion of the reaction container.
